Europäisches Patentamt

European Patent Office

Office européen des brevets

Publication number: **0 290 821**

**A2**

# EUROPEAN PATENT APPLICATION

Application number: **88106195.6**

Date of filing: **19.04.88**

Int. Cl.⁴ **H01R 9/09**

Priority: **11.05.87 IT 6036987 U**

Date of publication of application:
**17.11.88 Bulletin 88/46**

Designated Contracting States:
**DE ES FR GB**

Applicant: **EATON CONTROLS SpA**
**Via Edolo 26**
**I-20125 Milano(IT)**

Inventor: **De Biasi, Virgilio**
**via Nongole 166**
**I-32100 Belluno(IT)**
Inventor: **Scussel, Adriano**
**Via Nogarè 19c**
**I-32100 Belluno(IT)**

Representative: **Petraz, Gilberto Luigi**
**G.L.P. S.a.s. di Gilberto Petraz P.le Cavedalis**
**6/2**
**I-33100 Udine(IT)**

## Multiple electrical connections for mechanical timers.

Multiple electrical connections for cam-type mechanical timers, which are suitable to enable the outward connectors, or terminals, (26) to be organized in the terminal board as required and the electrical connection to be made with insulated electrical leads (15-115), the organization of the outward connectors being embodied with circuit-holder plates (16-17) in which the plates (16) for the power connections contain circuits (18) made of sheared sheet metal and comprising protruding angled shoes (20), which are correlated with the metallic edge (25) of holes (19-24) included in the plates (16-17) cooperating together.

fig. 2

## "MULTIPLE ELECTRICAL CONNECTIONS FOR MECHANICAL TIMERS"

This invention concerns multiple electrical connections located downstream of a mechanical programmer device. The programmer devices with which the invention is concerned are normally called "timers" and have the purpose of conditioning in sequences which can be chosen as desired the functions proper to a machine or device with which such timers are associated.

The timers can control and govern multiple functions at one and the same time.

The invention is concerned preferably, but not only, with timers employed in washing and drying machines for household, community or industrial use.

From an actual timer itself there departs a plurality of terminals the departure position of which is governed by the axial assembly of the various cams and relative contact-holder supports, which form the storage means of the timer itself.

A correct design can organize only partly the rational arrangement of such terminals in view of the circumferential sequence of the activations.

Moreover, every person who has to apply such apparatus must have the usage means organized in the terminal board which groups and arranges in order the terminals in an individualized manner so as to facilitate the assembly, maintenance, connections, etc.

Furthermore, every person applying such apparatus requires that between the exit of the contact from the timer and the corresponding exit in the individualized terminal board there may be specific applications which have an effect on, or arise from, the signal passing through such contact.

Besides, some outward connectors or terminals serve to provide distribution and governing signals, whereas other connectors or terminals serve to feed, even if only momentarily, electrical power suitable to operate motors, solenoid valves, electrical resistors, etc.

For this reason plates are normally fitted in association with the timer which are suitable to connect in a logical manner the semi-random outward connectors from the timer to the organized and individualized outward connectors required in the terminal board.

When such plates are fitted to the timer, problems are raised with regard to electrical connections and to the continuity of such connections in the long term.

Problems concerning capacity are also raised as the normal printed circuits are not always able to withstand the electrical power loads required by the usage means.

Moreover, problems are involved with regard to the assembly, assembly work, the quality of the joint and the stability of the joint in the long term.

The more it is necessary to arrange to perform such operations wholly or partly in an automatic manner, the more serious these problems regarding the assembly and joints become.

The plates are embodied at the present time by means of printed circuits and may be assembled with the timer singly or more than one in number.

Such known embodiment does not meet the requirements of speed, quality and retention of quality in the long term.

The present applicant has designed, tested and embodied this invention so as to overcome the above drawbacks and obtain a rational, individualized organization of the outward connectors in correspondence with the terminal board.

According to the invention a wafer plate is provided in cooperation with the outward leads from the timer; but by wafer plate is meant a plate with at least the power circuits made of sheared sheet metal and cooperating with a support plate.

Such sheared metal circuits may be applied to the support plate or sunk therewithin by fusion.

The support plate is made of a plastic material and performs support and insulation functions.

Such wafer plate may itself bear the organized outward connectors of the terminal board, or else the outward connectors of the terminal board may be positioned on another plate, for instance a printed circuit plate.

According to the invention the outward connectors from the timer and the connecting shoes provided in the sheared metal circuit cooperate mutually by sliding against each other so as to obtain, above all, a stable mechanical contact.

According to a variant a plate is provided which bears printed circuits suitable to act as means to transfer control and governing signals.

A variant of the invention arranges for wafer plates comprising more than one circuit made of sheared sheet metal, each set of circuits lying on different planes.

A further variant of the invention provides for a plate bearing printed circuits and circuits made of sheared sheet metal.

The invention is therefore embodied with multiple electrical connections for cam-type mechanical timers, which are suitable to enable the outward connectors, or terminals, to be organized in the terminal board as required and the electrical connection to be made with insulated electrical leads, the organization of the outward connectors being embodied with circuit-holder plates in which the plates for the power connections contain circuits made of sheared sheet metal and comprising protruding angled shoes, which are correlated with the metallic edge of holes included in the plates cooperating together.

The attached figures, which are given as a non-restrictive example, show the following:-

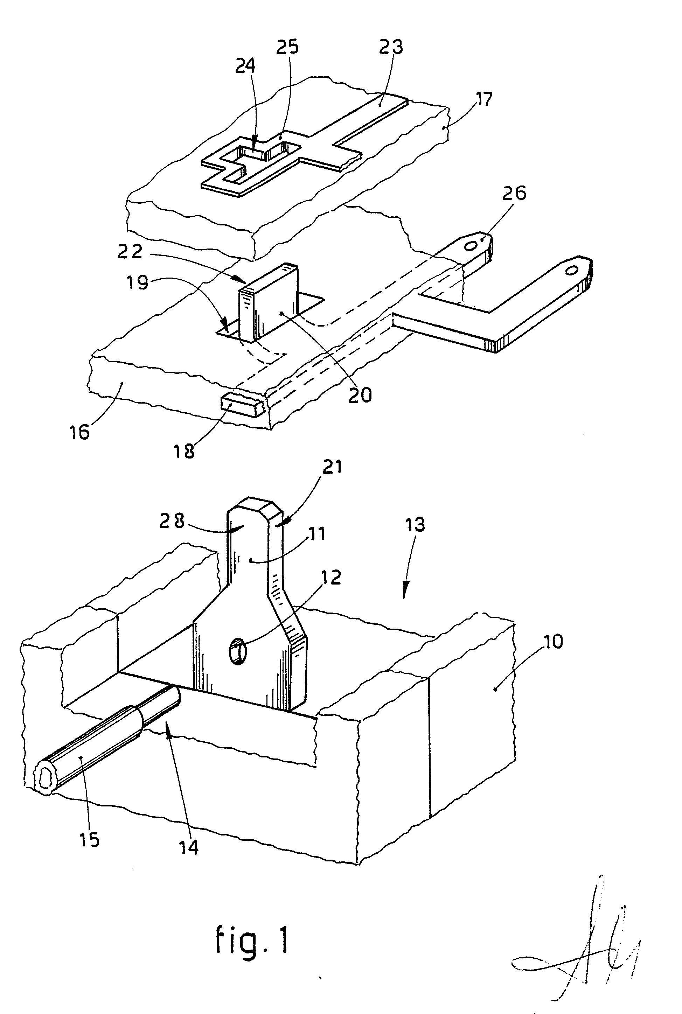

Fig.1 shows in a disassembled condition a connection according to the invention;

Fig.2 shows a disassembled variant of the connection;

Figs.3 to 7 show sections of possible types of connection according to the invention.

A timer 10 comprises a terminal 11 containing a hole 12. One timer 10 includes a plurality of terminals 11, all of which are located on a surface 13 of the timer 10.

Such terminals 11 may be aligned or be positioned on one or more lines along the length of the timer 10.

The position of the terminals 11 will depend on the position of the mechanical storage means (cam), on the angular position of the storage means and on the sequence arranged.

The hole 12 is suitable to cooperate with an end 14 of a lead 15 without its sheath. Such leads 15 can be used to create bridges, auxiliary connections, branches, etc. by connecting together the terminals 11 or outward connectors leaving the timer 10 and by making use of the holes 12.

Wafer plates 16 and, possibly, printed circuit plates 17 cooperate with the terminals 11. The wafer plates 16 are obtained by sinking sheared sheet metal circuits 18 therein as in the example shown.

The wafer plates 16 may be obtained also by applying such sheared sheet metal circuits 18 to appropriate plates comprising suitable positioning and clamping means.

The wafer plates 16 serve advantageously to convey electric power to usage means requiring such power, such as motors, resistors, solenoid valves,etc.

The wafer plates 16 contain a plurality of through holes 19 passing therethrough. Such holes 19 cooperate directly with the terminals 11 and therefore are present in at least the same number as the terminals but may be included in a greater number, as we shall see later.

The holes 19 are included for the passage of the terminals 11 or the ends 114 of a cable 115; if the terminals or cable are not comprised, then the holes 19 may be missing.

The circuits 18 in correlation with the holes 19, which, as said above, may be present not as through holes as such but only as outward passages, comprise shoes 20 folded so that they can be positioned with a desired angle in relation to the wafer plate 16.

It is therefore possible to fit the wafer plate 16 to the surface 13 of the timer 10 so that the terminals 11 cooperate with the respective holes 19, which will be shaped suitably to receive the terminals 11.

In this way a sidewall 21 of the terminal 11 cooperates with, by sliding against and slightly altering the trim of, a face 22 of the shoe 20 made in the circuit 18.

A mechanical and electrical contact in the form of a "T" is thus created between the terminal 11 and the shoe 20.

As the terminal 11 is produced by shearing, its sidewalls 21 will have their own specific consequent roughness, which cooperates with the surface 22 of the shoe 20 in improving the contact.

A wafer plate 16 contains within itself a plurality of single circuits 18, with which it is possible to produce bridges between the terminals 11, auxiliary connections, branches, etc.

At a desired position, in the terminal board for instance, the circuits 18 are arranged in the required organized form and may comprise a plurality of their own terminals or outward connectors 26. One single circuit 18 may comprise one or more terminals or outward connectors 26.

If the wafer plate 16 is not enough to obtain all the connections, it is possible according to the invention to provide also at least one printed circuit plate 17.

The printed circuit plate 17 will contain a coordinated series of holes 24, which are surrounded by a metallic edge 25 that is helpful for soldering purposes.

Depending on the type of connection to be produced, the metallic edge 25 will be connected electrically, that is to say, it will form an integral part of one single printed circuit 23, or will not be connected electrically to one single printed circuit 23.

A printed circuit plate 17 cooperating with a wafer plate 16 will contain as many holes 24 as there are shoes 20, and the positioning of the holes and shoes will coincide and be reciprocal.

Thus there will be holes 19-24 cooperating with terminals 11, and there will be shoes 20 and holes 24 cooperating with each other.

The holes 24 which have to cooperate also with the terminals 11 will be T-shaped so that they can accommodate the terminal 11 as well as the shoe 20.

If the holes 24 have to cooperate only with the shoes 20, their conformation will be such as to accommodate the shoe 20, which passes through the support plate 17 and substantially protrudes therefrom.

It may happen that the number of connections to be provided will be such as to make insufficient the use of the leads 15, the wafer plates 16 and the printed circuit plates 17.

It may also become necessary to be able to make auxiliary connections after the timer 10 and the wafer and support plates 16-17 have been assembled.

In such cases the conformation of the hole 24 in the support plate and possibly also of the hole 19 in the wafer plate may be altered to provide one or more notches 27 able to accommodate the sheathless end 114 of the cable 15. Such end 114 cooperates also with one of the two end surfaces 28 of the terminal 11 and is suitable to protrude substantially from the support plate 17.

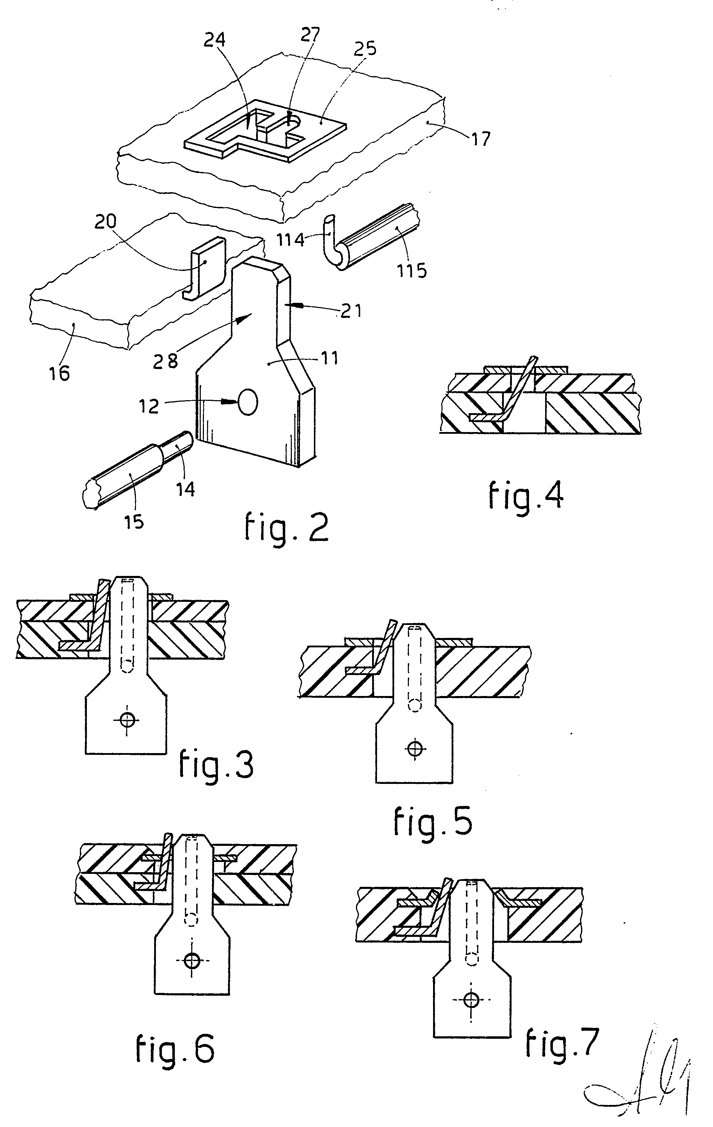

Fig.3 shows a section of the connection which takes place between the terminal 11, circuit 18 and metallic edge 25.

The final connection between the terminal 11, shoe 20, metallic edge 25 and cable 114 or between two or more of the same, that is, between the various metallic items protruding from the same hole 24 or connection point, is made stable by means of soldering.

The conformation obtained enables the soldering to be produced in a soundwave bath and therefore in an automatic manner.

Fig.4 shows the case of an electrical connection made only between a wafer plate 16 and a printed circuit plate 17.

Fig.5 shows an example where a printed circuit 23 is produced on the wafer plate 16.

Fig.6 shows a case where two separate wafer plates 16 are employed.

Fig.7 shows an example of a wafer plate 16 consisting of two sets of sheared metal circuits.

## Claims

1 - Multiple electrical connections for cam-type mechanical timers, which are suitable to enable the outward connectors, or terminals, (26) to be organized in the terminal board as required and the electrical connection to be made with insulated electrical leads (15-115), the organization of the outward connectors being embodied with circuit-holder plates (16-17) in which the plates (16) for the power connections contain circuits (18) made of sheared sheet metal and comprising protruding angled shoes (20), which are correlated with the metallic edge (25) of holes (19-24) included in the plates (16-17) cooperating together.

2 - Multiple electrical connections for cam-type mechanical timers, which are suitable to enable the outward connectors, or terminals, (26) to be organized in the terminal board as required and the electrical connection to be made with insulated electrical leads (15-115), the organization of the outward connectors being embodied with circuit-holder plates (16-17) in which the plates (16) for the power connections contain circuits (18) made of sheared sheet metal and comprising transit holes (19) and protruding angled shoes (20), which cooperate at least with sidewalls (21) of terminals (11) protruding from the mechanical timer (10).

3 - Multiple electrical connections as claimed in Claim 1 or 2, in which the holes (19-24) have a rectangular plan.

4 - Multiple electrical connections as claimed in Claim 1 or 2, in which the holes (19-24) have a T-shaped plan.

5 - Multiple electrical connections as claimed in any claim hereinbefore, in which the holes (19-24) comprise at least one notch (27) able to accommodate an end (114) of an electrical cable (115).

6 - Multiple electrical connections as claimed in any claim hereinbefore, in which the various metallic items (11-20-114) protruding from the same hole (24) are soldered to the metallic edge surrounding that hole (24).

fig.1

fig. 2

fig.4

fig.3

fig.5

fig.6

fig.7